# EUROPEAN PATENT APPLICATION

(11) **EP 2 043 316 A1**
(43) Date of publication of application: **01.04.2009**
(21) Application number: 07117509.5
(22) Date of filing: 28.09.2007
(51) Int. Cl.: H04L 27/26

(54) **A method for peak limiting of transmit power for radio transmission, a transmitter, a base station, a mobile station and a communication network therefor**

(71) Applicant: LUCENT TECHNOLOGIES INC., Murray Hill NJ 07974-0636 (US)
(72) Inventor: Obernosterer, Frank, 90411 Nürnberg (DE)
(74) Representative: Brose, Gerhard

(57) **Abstract**

The invention concerns a method for peak limiting of transmit power for radio transmission, whereby an original signal at a detected peak of transmit power is multiplied by a clipping factor (SFC) resulting in a clipping signal, said clipping signal is filtered using at least two clipping filter coefficients (ACF) resulting in a correction signal, and said correction signal is added to the original signal in the time domain (SUM), a transmitter, a base station, a mobile station and a communication network therefor.

## Description

The invention relates to a method for peak limiting of transmit power for radio transmission according to the preamble of claim 1, a transmitter according to the preamble of claim 8, a base station according to the preamble of claim 9, a mobile station according to the preamble of claim 10 and a communication network according to the preamble of claim 11.

In most wireless digital communication systems, like e.g. the Global System for Mobile Communication (GSM), the Worldwide Interoperability for Microwave Access (WiMAX), the Universal Mobile Telecommunications System (UMTS), or the so-called Long Term Evolution of UMTS, the transmit power amplifier is contributing significantly to the total costs of both infrastructure, i.e. base stations, and user equipment, i.e. mobile stations. One state-of-the-art approach to increase the efficiency of a power amplifier and thus minimize costs of the power amplifier is the application of digital peak limiting techniques, which are known as clipping or peak-to-average-reduction.

In order to achieve a high power amplifier efficiency, large peaks in the transmit signal have to be avoided to the greatest possible extent. The related metric is the peak-to-average ratio (PAR), which should be as small as possible from amplifier efficiency point of view.

However, the clipping, i.e. the removal of peaks above a given threshold, inevitably introduces a deviation of the signal relative to its original waveform. This error signal is often denoted as clipping noise. In all significant wireless communication standards, the power of the overall error signal is limited by specification in respective requirements documents. One of the technical terms relevant in this context is the so-called error vector magnitude (EVM), which quantifies the amount of clipping noise and which has to be kept below specified limits.

There are various different approaches for digital peak limiting. It is common to all state-of-the-art approaches to basically make the spectral shape of the clipping noise, i.e. of the error signal between original and peak limited waveform, similar to the shape of the composite useful signal.

When employing a Frequency Division Multiple Access (FDMA) transmission system with multiple frequency channels, i.e. subcarriers, this means that clipping noise is nearly equally distributed among these frequency channels, independent of their potentially different EVM requirements which e.g. arise from different applied modulation types.

In the US patent US 6654427 B1, a peak-limiting technique which reduces the peak-to-average ratio and which is known as signal notching is described. In this patent, it is disclosed, that the peak of a signal above a threshold is notched. Then, the notched signal is filtered to produce a resulting signal with a reduced peak amplitude. This document is regarded as the closest prior art for the invention.

The shortcoming of the known approaches is the fact that each frequency channel faces a similar amount of clipping noise. In a Frequency Division Multiple Access system like e.g. UMTS Long Term Evolution (LTE) or WiMAX, multiple users are served simultaneously by allocating different frequency channels with different modulation types such as Quadrature Phase Shift Keying (QPSK), 16-QAM or 64-QAM modulation (QAM = Quadrature Amplitude Modulation). In general, a higher order modulation (HOM) such as 64-QAM poses much higher requirements on transmit signal EVM than a lower order modulation such as e.g. QPSK.

If higher order modulation is applied and all subcarriers face approximately the same clipping noise, then only a small PAR reduction is possible, as the total EVM has to be kept low due to the involved higher order modulation. However a high PAR makes the power amplifier rather inefficient and costly, as much headroom has to be foreseen to cope with large signal peaks.

The object of the invention is thus to propose a method of signal processing for peak limiting in a wireless system employing Frequency Division Multiple Access (FDMA), such as the UMTS Long Term Evolution (LTE) system or the WiMAX system, that offers on the one hand the possibility to concentrate the clipping noise in those subcarriers of the composite signal which are relatively insensitive to EVM, e.g. due to the usage of lower order modulation such as Binary Phase Shift Keying (BPSK), or Quadrature Phase Shift Keying (QPSK), and on the other hand allows for a reduction of clipping noise in those subcarriers which are used with higher order modulation such as e.g. 64-QAM.

This object is achieved by a method according to the teaching of claim 1, a transmitter according to the teaching of claim 8, a base station according to the teaching of claim 9, a mobile station according to the teaching of claim 10, and a communication network according to the teaching of claim 11.

The main idea of the invention is to combine an original signal the time domain with a correction signal. Said correction signal is derived from the original signal at a detected peak of transmit power by multiplication with a clipping factor and filtering using at least two clipping filter coefficients.

The power of the resulting signal after addition of the correction signal to the original signal in the time domain can be designed by means of choosing an appropriate clipping factor for clipping the original signal at the detected peak in such a way that a given transmit power threshold will not be exceeded.

Further developments of the invention can be gathered from the dependent claims and the following description.

In the following the invention will be explained further making reference to the attached drawings.
Fig. 1 schematically shows the power spectral density (PSD) of signals and clipping noise according to the state-of-the-art.
Fig. 2 schematically shows the basic operation of peak notching employing adaptive clipping filter according to the invention.
Fig. 3 schematically shows the power spectral density (PSD) of signals and clipping noise according to the invention.
Fig. 4 schematically shows the power spectral density (PSD) of signals and clipping noise according to the invention for subcarriers used for payload or control data and pilot symbol transmission.

According to approaches for digital peak limiting of the prior art, the resulting clipping noise is nearly equally distributed over the subcarriers independent of their respective EVM requirements.

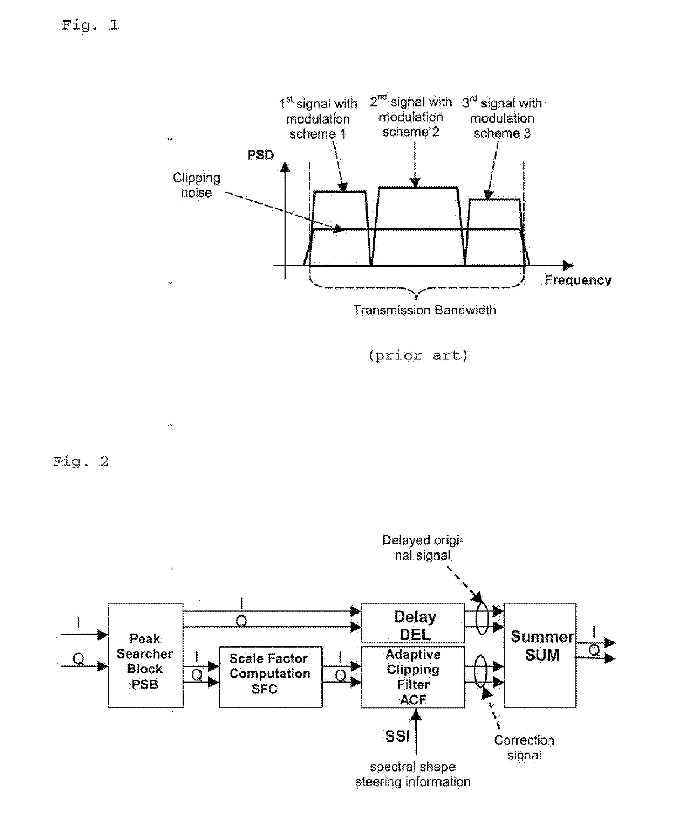

Fig. 1 shows the power spectral density (PSD) of signals and clipping noise plotted against the frequency according to the prior art approaches. Exemplarily, three signals each with a different modulation scheme are depicted. It is assumed, that the first and the third signal use modulation schemes with relaxed EVM requirements, as e.g. BPSK or QPSK, whereas the second signal uses higher order modulation with more stringent EVM requirements, as e.g. 64 QAM.

As the clipping noise according to the prior art approaches is equally distributed over the transmission bandwidth, only a small PAR reduction is possible, as the total error vector magnitude has to be kept low due to the involved higher order modulation of the second signal.

According to the invention, a method is provided for limiting one or more peaks of a composite FDMA signal having at least two subcarrier signals at respective frequency bandwidths.

The method according to the invention allows for concentration of the clipping noise in those subcarriers of the composite signal which are relatively insensitive to EVM, e.g. due to lower order modulation, such as BPSK or QPSK. On the other hand those subcarriers which are using higher order modulation such as e.g. 64-QAM shall face less clipping noise.

Fig. 2 schematically shows in a block diagram a system for peak limiting of transmit power for radio transmission according to the invention.

A peak searcher block PSB comprises an input for an in-phase path I and an input for a quadrature path Q. Said peak searcher block PSB comprises output connections for an in-phase path I and for a quadrature path Q both to a delay module DEL and a scale factor computation module SFC.

Said scale factor computation module SFC comprises output connections for an in-phase path I and for a quadrature path Q to an adaptive clipping filter module ACF. Said adaptive clipping filter module ACF comprises an input for spectral shape steering information SSI.

Both the delay module DEL and the adaptive clipping filter module ACF comprise output connections for an in-phase path and for a quadrature path to a summer SUM.

The summer SUM in turn comprises output connections for an in-phase path I and for a quadrature path Q.

A composite signal that is intended to be sent over a radio interface is sent over the in-phase path I and the quadrature path Q to the peak searcher block PSB. In the peak searcher block PSB, within a window of samples of the composite signal, it is detected whether one or more peaks of the composite signal have a transmit power that is higher than a given transmit power threshold.

The composite signal is then sent from the peak searcher block PSB on the one hand to the delay module DEL, and on the other hand to the scale factor computation module SFC. Furthermore, the peak searcher block PSB sends information to the scale factor computation module SFC that allow for an identification of the peaks of the composite signal that have a transmit power that is higher than a given transmit power threshold.

The composite signal at a peak having a transmit power higher than a given transmit power threshold, which is a complex value, is multiplied by a clipping factor, which is preferable real-valued, in the scale factor computation module SFC resulting in a clipping signal, which again is a complex number.

The scale factor computation module SFC sends said clipping signal to the adaptive clipping filter module ACF. In said adaptive clipping filter module ACF, said clipping signal is filtered using at least two clipping filter coefficients resulting in a correction signal. The correction signal has a spectral shape that is determined by said at least two clipping filter coefficients and that distributes energy, i.e. the clipping noise, unequally and in a desired and well-defined way across the frequency channels, i.e. subcarriers. At least two clipping filter coefficients are necessary, as with only one clipping filter coefficient, the energy, i.e, the clipping noise, can only be distributed equally across the frequency channels.

The adaptive clipping filter module ACF sends the correction signal to the summer SUM.

The composite signal that has been sent from the peak searcher block to the delay module is delayed in said delay module and then also sent to the summer SUM.

The delay module DEL determines the delay of the composite signal that compensates for the processing and transmission time of the signal path between the peak searcher block PSB and the summer SUM via the scale factor computation module SFC and the adaptive clipping filter module ACF. Said delay of the composite signal is either predetermined before transmission in the delay module DEL, or dynamically determined during transmission by a control module and sent to the delay module DEL based on information about processing time from the scale factor computation module SFC or the adaptive clipping filter module ACF. The control module and its connection to the delay module DEL are not shown in fig. 2 for the sake of simplicity.

The correction signal and the delayed composite signal are then combined, i.e. added, in the summer SUM in the time domain without any time shift between said two signals, so that the detected peak of the composite signal and the detected peak of the composite signal after multiplication by the clipping factor and by said at least two clipping filter coefficients which belongs to the correction signal are located at the same point in time.

As the correction signal and the delayed composite signal are added, the correction signal can be interpreted as clipping noise.

The addition of the correction signal and the delayed composite signal leads to a clipped and filtered signal, which is provided at the output of the summer SUM.

The at least two clipping filter coefficients determine the average spectral shape of the clipping noise. According to the state-of-the-art approaches, the clipping filter coefficients are fixed and thus result in a fixed distribution of clipping noise across the transmit frequency bandwidth.

Thus, in a preferred embodiment of the invention, the clipping filter is computed adaptively depending on the respective desired spectral distribution of the clipping noise. Said at least two clipping filter coefficients are e.g. determined in such a way, that the power distribution over subcarriers of the correction signal is correlated with the noise sensitivity of the subcarriers. In order to be able to determine the appropriate at least two clipping filter coefficients, the adaptive clipping filter module ACF needs information about the desired spectral distribution of the clipping noise, which is sent to the adaptive clipping filter module ACF e.g. by a control module in form of spectral shape steering information SSI. For the sake of simplicity, said control module is not shown in fig. 2.

If the respective desired spectral distribution of the clipping noise is not time dependent, said at least two clipping filter coefficients are only once determined before the radio transmission starts.

If the respective desired spectral distribution of the clipping noise is time dependent, said at least two clipping filter coefficients may e.g. vary from time slot to time slot or from OFDM symbol to OFDM Symbol in a OFDMA based transmission system. Basically, if the noise sensitivity of the subcarriers is time dependent, said at least two clipping filter coefficients are repeatedly determined during radio transmission.

In another preferred embodiment of the invention, sets of said at least two clipping filter coefficients, each assigned to a dedicated distribution of noise sensivity over subcarriers, are determined before radio transmission, stored in a memory and read out by a filter dependent on a given distribution of noise sensitivity over subcarriers.

The clipping factor is determined in such a way, that the power of the resulting signal after addition of the correction signal to the delayed composite signal in the time domain is not higher than a transmit power threshold.

In order to be,able to determine the appropriate clipping factor, the scale factor computation module SFC needs information about said at least two clipping filter coefficients, which is sent to the scale factor computation module SFC e.g. by a control module or directly by the adaptive clipping filter module ACF. For the sake of simplicity, said control module is not shown in fig. 2.

The step of generating a correction signal and the step of combining the correction signal with a delayed composite signal may be repeated for a plurality of sample windows of the composite signal.

Such a system for peak limiting of transmit power for radio transmission as described above can be comprised in a transmitter used for transmission in a base station or a mobile station that are part of a communication network.

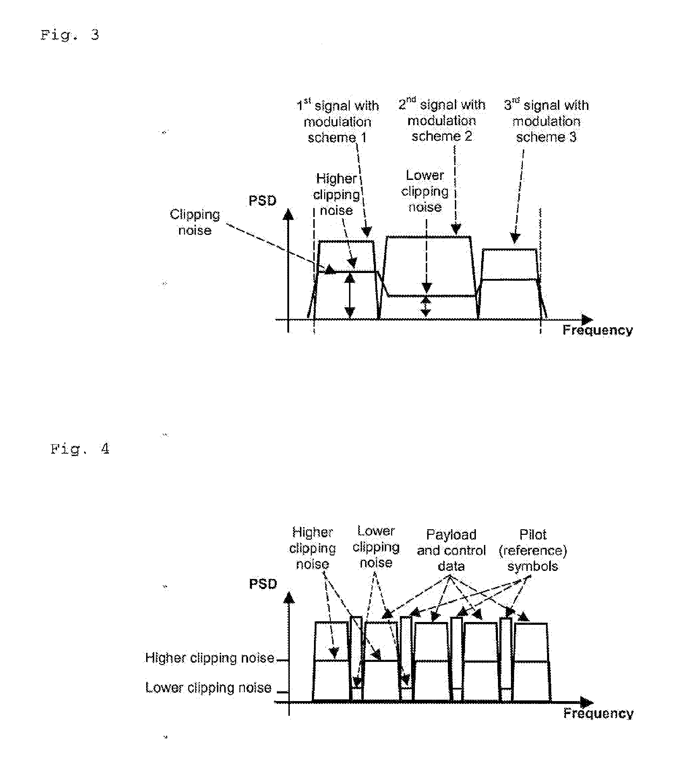

Fig. 3 shows the power spectral density PSD of signals and clipping noise plotted against the frequency that can be achieved by a method according to the invention. As in the case of the prior art approaches shown in fig. 1, exemplarily, three signals each with a different modulation scheme are depicted. Again, it is assumed, that the first and the third signal use modulation schemes with relaxed EVM requirements, as e.g. BPSK or QPSK, whereas the second signal uses higher order modulation with more stringent EVM requirements, as e.g. 64 QAM.

The at least two clipping filter coefficients are determined in such a way, that the resulting clipping noise is higher in the frequency range of the first and third signal compared to the clipping noise in the frequency range of the second signal.

Thus, a higher PAR reduction can be achieved than in case of an equal distribution of clipping noise over the whole frequency bandwidth.

Fig. 4 shows as a concrete application of the invention the power spectral density PSD of signals and clipping noise for subcarriers used for payload or control data and pilot symbol transmission plotted against the frequency.

At a receiver side, the pilot symbols are used for channel estimation, which is crucial for the overall performance of the receiver in terms of bit and frame error rates. If the pilot symbols are considerably distorted by clipping noise, the quality of the channel estimation suffers, which can result in overall throughput and thus system performance degradation. This aspect is even more important in upcoming multiple antenna wireless systems, which have higher requirements regarding channel estimation quality. In UMTS LTE, the application of multiple input multiple output (MIMO) techniques is part of the 3GPP standard (3GPP = Third Generation Partnership Project).

Thus, in subcarriers that are used for pilot or reference symbol transmission, only a low clipping noise is desired, as undistorted pilot symbols allow for a better channel estimation at the mobile receiver side and thus result in an increased system capacity or throughput.

The at least two clipping filter coefficients are determined in such a way, that the resulting clipping noise is higher in the frequency range of signals used for payload or control data compared to the clipping noise in the frequency range of signals used for pilot or reference symbol.

Thus, as can be seen in fig. 4, clipping noise is concentrated in those subcarriers of the composite signal which are not carrying pilot or reference symbols and which are typically protected by forward error correction (FEC), and clipping noise is avoided in all pilot or reference symbol carrying subcarriers. This allows for a better channel estimation on the receiver side.

If a MIMO technology is applied, the at least two clipping filter coefficients are preferably different for each antenna, if the pilot carrying frequency channels are not identical for each antenna.

In conclusion, the application of the invention allows the operation of a power amplifier at an increased efficiency, which can be either exploited to increase the output power provided by a given power amplifier, or to use a cheaper amplifier device with lower output power.

## Claims

1. A method for peak limiting of transmit power for radio transmission, whereby an original signal at a detected peak of transmit power is multiplied by a clipping factor (SFC) resulting in a clipping signal, **characterized in, that**
• said clipping signal is filtered using at least two clipping filter coefficients (ACF) resulting in a correction signal,
• and said correction signal is added to the original signal in the time domain (SUM).

2. A method according to claim 1, **characterized in, that** said at least two clipping filter coefficients are determined in such a way, that the power distribution over subcarriers of the correction signal is correlated with the noise sensitivity of the subcarriers.

3. A method according to claim 2, **characterized in, that** said at least two clipping filter coefficients are determined before the radio transmission starts.

4. A method according to claim 3, **characterized in, that** if the noise sensitivity of the subcarriers is time dependent, said at least two clipping filter coefficients are repeatedly determined during radio transmission.

5. A method according to claim 2, **characterized in, that** sets of said at least two clipping filter coefficients, each assigned to a dedicated distribution of noise sensitivity over subcarriers, are determined before radio transmission, stored in a memory and read out by a filter dependent on a given distribution of noise sensitivity over subcarriers.

6. A method according to claim 1, **characterized in, that** said clipping factor is determined in such a way that the power of the resulting signal after addition of the correction signal to the original signal in the time domain is not higher than a transmit power threshold.

7. A method according to claim 1, **characterized in, that** said at least two clipping filter coefficients are determined in such a way, that the transmit power of the correction signal is lower in subcarriers that carry pilot signals than in subcarriers that carry payload or control data.

8. A transmitter using peak limiting of transmit power for radio transmission, whereby said transmitter comprises at least one processing means adapted to perform multiplication of an original signal at a detected peak of transmit power by a clipping factor (SFC), said multiplication resulting in a clipping signal, **characterized in, that**
• said at least one processing means is adapted to perform filtering of said clipping signal using at least two clipping filter coefficients (ACF), said multiplication resulting in a correction signal,
• and said at least one processing means is adapted to perform addition of said correction signal to the original signal in the time domain (SUM).

9. A base station comprising at least one transmitter using peak limiting of transmit power for radio transmission, whereby said transmitter comprises at least one processing means adapted to perform multiplication of an original signal at a detected peak of transmit power by a clipping factor (SFC), said multiplication resulting in a clipping signal, **characterized in, that**
• said at least one processing means is adapted to perform filtering of said clipping signal by at least two clipping filter coefficients (ACF), said multiplication resulting in a correction signal,
• and said at least one processing means is adapted to perform addition of said correction signal to the original signal in the time domain (SUM).

10. A mobile station comprising at least one transmitter using peak limiting of transmit power for radio transmission, whereby said transmitter comprises at least one processing means adapted to perform multiplication of an original signal at a detected peak of transmit power by a clipping factor (SFC), said multiplication resulting in a clipping signal, **characterized in, that**
• said at least one processing means is adapted to perform filtering of said clipping signal using at least two clipping filter coefficients (ACF), said multiplication resulting in a correction signal,
• and said at least one processing means is adapted to perform addition of said correction signal to the original signal in the time domain (SUM).

11. A communication network comprising at least one base station or at least one mobile station comprising at least one transmitter using peak limiting of transmit power for radio transmission, whereby said transmitter comprises at least one processing means adapted to perform multiplication of an original signal at a detected peak of transmit power by a clipping factor (SFC), said multiplication resulting in a clipping signal, **characterized in, that**
• said at least one processing means is adapted to perform filtering of said clipping signal using at least two clipping filter coefficients (ACF), said multiplication resulting in a correction signal,
• and said at least one processing means is adapted to perform addition of said correction signal to the original signal in the time domain (SUM).
